Europäisches Patentamt

European Patent Office

Office européen des brevets

(19)

(11) **EP 0 821 492 A2**

(12) **EUROPEAN PATENT APPLICATION**

(43) Date of publication:
**28.01.1998 Bulletin 1998/05**

(51) Int Cl.⁶: **H03M 13/00**

(21) Application number: **97305079.2**

(22) Date of filing: **10.07.1997**

(84) Designated Contracting States:
**AT BE CH DE DK ES FI FR GB GR IE IT LI LU MC NL PT SE**

(30) Priority: **24.07.1996 JP 212188/96**

(71) Applicant: **MATSUSHITA ELECTRIC INDUSTRIAL CO., LTD.**
**Kadoma-shi Osaka (JP)**

(72) Inventor: **Hiramatsu, Katsuhiko**
**Yokohama-shi (JP)**

(74) Representative: **Smith, Norman Ian et al**
**F.J. CLEVELAND & COMPANY**
**40-43 Chancery Lane**
**London WC2A 1JQ (GB)**

(54) **Error-correcting code generating circuit and modulator apparatus using the same**

(57)     An error-correcting code generating circuit includes a shift register (110, 111, 112, 113) incarnating a generating polynomial, an exclusive logical sum means (503), and a logical circuit means (105) for performing arithmetic operations on N bits (114, 115, 116, 117) (where N represents an integer not smaller than two) held by said shift register at one time with a clock (118) having a frequency corresponding to 1/N on the basis of N bits (101, 102, 103, 104)(where N represents an integer not smaller than two) inputted in parallel, to thereby generate an error-correcting code of N bits with a single-shot of clock. Because the error correcting code can be generated through the parallel processing, operation can be executed at a low speed with power consumption as involved being reduced.

## FIG.1

**Description**

BACKGROUND OF THE INVENTION

The present invention generally relates to an error-correcting code generating circuit and a modulator apparatus including the same which are employed, for example, in a transmitter for a digital mobile communication. More particularly, the invention is concerned with the error-correcting code generating circuit and the modulator apparatus which are capable of reducing significantly the power consumption involved in the error-correcting code generating processing as well as in the modulation processing.

Description of Related Art

In the digital communication, the information bit string to be transmitted is usually added with check bits for error detection and correction at the transmitter or sender side, in order to make it possible to perform error detection and correction of the information bits received at the receiver side. To this end, there is employed the error-correcting code generating circuit. Concerning the conventional error-correcting code generating circuits known heretofore, detailed description can be found, for example, in H. Imai: "FUGOU RIRON (Code Theory)" published by Corona-Sha company of Japan, pp. 115-118.

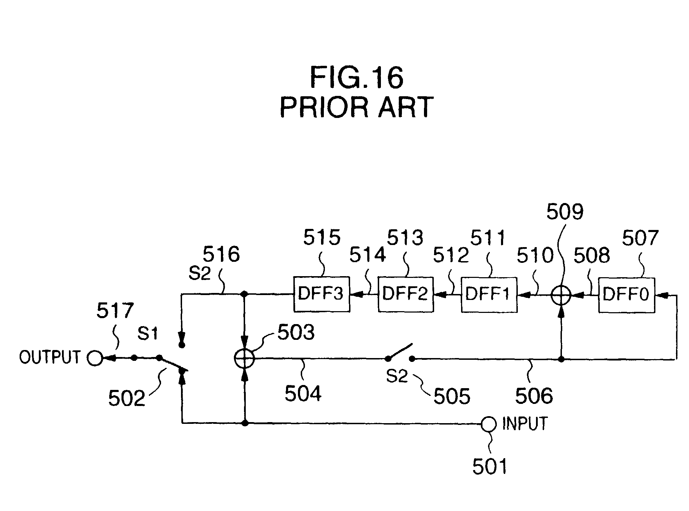

Figure 16 of the accompanying drawings is a circuit diagram showing a structure of a hitherto known or conventional error-correcting code generating circuit incarnating a generating polynomial given by the following expression:

$$G(x) = X^4 + x + 1 \tag{1}$$

Referring to Fig. 16, the conventional error-correcting code generating circuit is comprised of an input terminal 501 to which information bit string is inputted, a divider circuit for dividing a generating polynomial represented by the information bit string inputted by the generating polynomial $G(x)$ to thereby determine the residue, a switch 502 for changing over the signal path so that the residue calculated by the divider circuit is outputted in succession to the information bits, and an output terminal 517 for outputting a block code containing the information bit string added with the above-mentioned residue.

On the other hand, the aforementioned divider circuit is comprised of a shift register constituted by a D-flip-flop (DFF0) 507, a D-flip-flop (DFF1) 511, a D-flip-flop (DFF2) 513 and a D-flip-flop (DFF3) 515, an adder circuit 503 for determining an exclusive logical sum (Exclusive-OR) between the output of the D-flip-flop (DFF3) 515 and the input information bits, an adder circuit 509 for determining an exclusive logical sum (Exclusive-OR) between the output of the adder circuit 503 and that of the D-flip-flop (DFF0) 507, and a switch 505 which is turned on when the switch 502 is connected to the input terminal 501 while being turn off when the switch 502 is closed to the divider circuit.

In the conventional error-correcting code generating circuit described above, the switch 502 is closed to the input terminal 501 so long as the information bits are inputted to the input terminal 501 with the input bit signal being outputted intact from the output terminal 517. At that time point, the switch 505 is closed, whereby the previously mentioned division for the input bit string is performed concurrently through cooperation of the D-flip-flops 507, 511, 513 and 515 and the adder circuits 503 and 507.

Upon disappearance of the input signal, the switch 502 is closed to the divider circuit with the switch 505 being opened. Thus, the data held by the D-flip-flop (DFF3) 515, the D-flip-flop (DFF2) 513, the D-flip-flop (DFF1) 511 and D-flip-flop (DFF0) 507, i.e., coefficients of the residue polynomial resulting from the division of the polynomial containing the coefficients given by the information bits by the generating polynomial $G(x)$, are sequentially outputted from the output terminal 517.

In this way, block codes each composed of the information bits and the check bits are outputted from the output terminal 517. At the receive side, the bit string as received is divided by the generating polynomial $G(x)$. When the division involves a residue, it is then decided that error is contained in the received bit string.

The conventional error-correcting code generating circuit described above suffers a problem that power consumption involved in the arithmetic operations increases as the signal rate increases, because the arithmetic operation has to be performed newly upon every inputting of one information bit or one clock.

SUMMARY OF THE INVENTION

In the light of the state of the art described above, it is an object of the present invention to provide an error-correcting code generating circuit which allows power consumption to be decreased or alternatively enables high-speed operation for a given power consumption when compared with the conventional error-correcting code generating circuit.

Another object of the present invention is to provide a modulator apparatus which allows power consumption to be decreased or alternatively ensures high-speed operation for a given power consumption when compared with the conventional error-correcting code generating circuit by employing the error-correcting code generating circuit mentioned above.

In view of the above and other objects which will become apparent as the description proceeds, the present invention teaches in conjunction with the error-correcting code generating circuit which includes a conventional shift register and exclusive-OR circuits that a logical circuit is provided for performing arithmetic operations on N bits (where N represents an integer not smaller than two) held by the shift register at one time with a clock having a frequency corresponding to 1/N on the basis of N bits (where N represents an integer not smaller than two) inputted in parallel, to thereby generate an error-correcting code of N bits with a single-shot of clock.

With the structure of the error-correcting code generating circuit according to the invention which is capable of generating the error-correcting code by resorting to the parallel processing as mentioned above, the arithmetic operation can be carried out at a low rate when compared with the conventional error-correcting code generating circuit with the power consumption of the process itself being reduced. This in turn means that for a given power consumption, the processing can be carried out at a high speed.

Furthermore, in the modulator apparatus according to the invention, the error-correcting code generating circuit, a modulator and a scrambler circuit are each so designed as to be capable of performing parallel processing.

Thus, the operation speed can be lowered with the power consumption being reduced. On the other hand, for a given power consumption, operation can be realized at a higher speed when compared with the conventional error-correcting code generating circuit known heretofore.

Thus, there is provided according to an aspect of the present invention, there is provided an error-correcting code generating circuit which includes a shift register incarnating a generating polynomial, Exclusive-OR circuits, and a logical circuit for performing arithmetic operations for N bits (where N represents an integer not smaller than two) held by the shift register at one time with a clock having a frequency corresponding to 1/N on the basis of N bits (where N represents an integer not smaller than two) inputted in parallel, to thereby generate an error-correcting code of N bits with a single-shot of clock. By virtue of the arrangement of the error-correcting code generating circuit described above, the error-correcting code can be generated through the parallel processing. Thus, the operation as required can be performed at a low speed as compared with the conventional error-correcting code generating circuit with the power consumption being correspondingly reduced.

According to another aspect of the present invention, there is provided a modulator apparatus which includes a parallel-input/parallel-output error-correcting code generating circuit for arithmetically generating an error-correcting code of plural bits with a single-shot of clock, and a parallel-input/parallel-output modulator for performing mapping of the plural bits to modulation signal points with a single-shot of clock. By virtue of this arrangement of the modulator apparatus, operation speed can be lowered with the power consumption being reduced because of the error-correcting code generation and the modulation realized through the parallel processing.

In a preferred mode for carrying out the invention in conjunction with the modulator apparatus described above, the parallel-input/parallel-output error-correcting code generating circuit may be prepared for each of two channels. Owing to this arrangement, error-correcting code can be generated for each of the channels separately.

In another preferred mode for implementing the modulator apparatus, there may further be provided a parallel-input/parallel-output scrambler circuit for scrambling a signal inputted to the parallel-input/ parallel-output modulator through parallel processing. By virtue of the above-mentioned arrangement, scramble processing can be achieved with reduced power consumption.

In a further preferred mode for carrying out the invention in conjunction with the modulator apparatus, the parallel-input/parallel-output scrambler circuit may be provided separately for two channels, respectively. With the arrangement mentioned above, the scramble processing can be executed for each of the channels separately.

The above and other objects, features and attendant advantages of the present invention will more easily be understood by reading the following description of the preferred embodiments thereof taken, only by way of example, in conjunction with the accompanying drawings.

BRIEF DESCRIPTION OF THE DRAWINGS

In the course of the description which follows, reference is made to the drawings, in which:

Fig. 1 is a block diagram showing a circuit configuration of an error-correcting code generating circuit according to a first embodiment of the present invention;
Fig. 2 is a view for illustrating a structure of input data for illustrating the concept of the invention;

Fig. 3 is a view for illustrating arithmetic operations performed by the error-correcting code generating circuit according to the first embodiment of the invention;

Fig. 4 is a circuit diagram showing a circuit configuration of a synthesizing circuit employed in the error-correcting code generating circuit according to the first embodiment of the invention;

Fig. 5 is a view for illustrating the operation of the error-correcting code generating circuit according to the first embodiment of the invention by comparing a parallel processing operation with a serial processing operation;

Fig. 6 is a circuit diagram showing a circuit configuration of a modulator apparatus according to a second embodiment of the present invention;

Figs. 7A and 7B are views showing schematically configurations of QPSK mapping circuits which can be employed in the modulator apparatus according to the second embodiment of the invention;

Fig. 8 is a view for illustrating operations of the QPSK mapping circuits shown in Fig. 7;

Figs. 9A to 9J are timing charts for illustrating operations of the modulator apparatus according to the second embodiment of the present invention;

Fig. 10 is a circuit diagram showing a circuit arrangement of the modulator apparatus according to a third embodiment of the invention;

Fig. 11 is a block diagram showing the principle of a scrambler circuit which can be employed in the modulator apparatus according to the third embodiment of the invention;

Fig. 12 is a view for illustrating operations of the scrambler circuit in the modulator apparatus according to the third embodiment of the invention;

Fig. 13 is a block diagram showing a circuit configuration of the scrambler in the modulator apparatus according to the third embodiment of the present invention;

Fig. 14 is a circuit diagram showing a circuit configuration of the modulator apparatus according to a fourth embodiment of the invention;

Fig. 15 is a circuit diagram showing a circuit configuration of the modulator apparatus according to a fifth embodiment of the present invention; and

Fig. 16 is a block diagram showing a configuration of a conventional error-correcting code generating circuit.

## DESCRIPTION OF THE PREFERRED EMBODIMENTS

Now, the present invention will be described in detail in conjunction with what is presently considered as preferred or typical embodiments thereof by reference to the drawings.

Embodiment 1

An error-correcting code generating circuit according to a first embodiment of the present invention will be described.

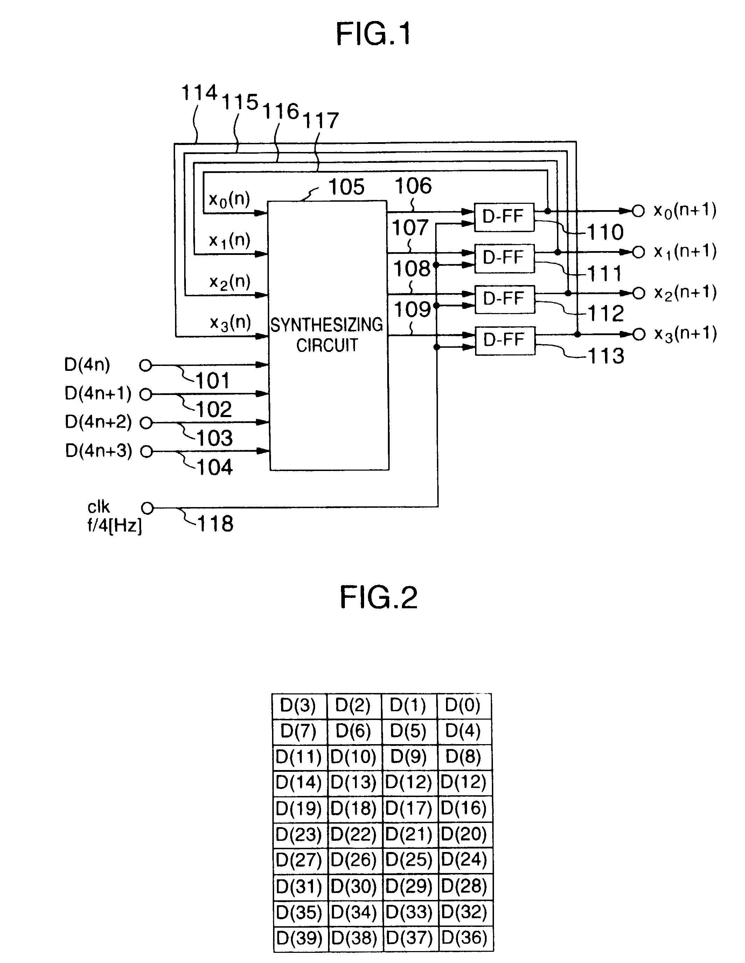

As is shown in Fig. 1, the error-correcting code generating circuit now under consideration is comprised of a synthesizing circuit 105 which is so designed as to perform logic operations by using input signals $D(4n)$, $D(4n + 1)$, $D(4n + 2)$ and $D(4n + 3)$ applied in parallel to the input terminals 101, 102, 103 and 104, respectively, of the synthesizing circuit 105 and output signals $x_0(n)$, $x_1(n)$, $x_2(n)$ and $x_3(n)$ of the error-correcting code generating circuit applied by way of input lines 114, 115, 116 and 117, respectively, and D-flip-flops 110, 111, 112 and 113 for latching the data outputted in parallel from the synthesizing circuit 105 at timings indicated by a clock signal clk inputted to a clock line 118.

In operation of the synthesizing circuit 105, at a time point $\underline{n}$, the four bit signals $D(4n)$, $D(4n + 1)$, $D(4n + 2)$ and $D(4n + 3)$ are inputted in parallel to the synthesizing circuit 105 together with the four bit signals $x_0(n)$, $x_1(n)$, $x_2(n)$ and $x_3(n)$ outputted from the D-flip-flops 110, 111, 112 and 113, respectively. In Fig. 2, there are illustrated, only by way of example, bit strings each of four bits inputted to the synthesizing circuit 105 at a same time point. In this case, it is assumed that the input signal is of 40 bits.

The synthesizing circuit 105 makes use of these input signals $D(4n)$, $D(4n + 1)$, $D(4n + 2)$ and $D(4n + 3)$ and $x_0(n)$, $x_1(n)$, $x_2(n)$ and $x_3(n)$ to thereby synthesize signals which are outputted to the D-flip-flops 110, 111, 112 and 113, respectively, to be latched at every fourth clock by the shift register of the conventional error-correcting code generating circuit described hereinbefore.

In this conjunction, it is assumed that the generating polynomial of concern is expressed as follows:

$$G(x) = x^4 + x + 1 \qquad (1)$$

In that case, the synthesizing circuit 105 synthesizes from the input signals the data to be latched by D-flip-flops 507, 511, 513 and 515 of the error-correcting code generating circuit shown in Fig. 16 at every fourth clock, wherein the data as generated are outputted, respectively, to the D-flip-flops 110, 111, 112 and 113 shown in Fig. 1.

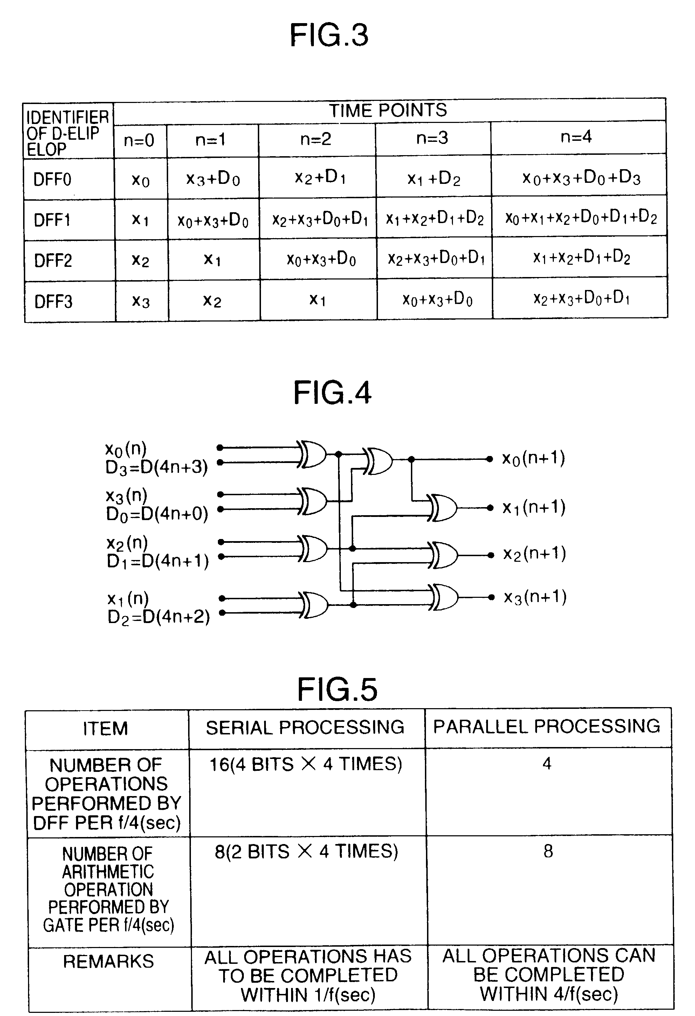

Figure 3 is a view showing, by way of example, the contents of the data latched by the D-flip-flops 507, 511, 513 and 515 of the error-correcting code generating circuit shown in Fig. 16 together with the changes in the data content as a function of time lapse from a time point n = 0 to a time point n = 4. More specifically, shown in Fig. 3 at the leftmost column are identifiers of the D-flip-flops 507, 511, 513 and 515, while shown at columns labeled "TIME" the contents of the data latched by the individual D-flip-flops 507, 511, 513 and 515 at time points n = 0, n = 1, n = 2, n = 3 and n = 4, respectively. As can be seen in Fig. 3, the data contents latched by the D-flip-flop (DFF0), the D-flip-flop (DFF1), the D-flip-flop (DFF2) and the D-flip-flop (DFF3) at the time point n = 0 are $x_0$, $x_1$, $x_2$ and $x_3$, respectively.

At this juncture, the data latched by the D-flip-flop (DFF0) 507 corresponds to an exclusive logical sum (Exclusive-OR) between the input signal and the preceding content of the D-flip-flop (DFF3) 515 (i.e., data held by this D-flip-flop at the preceding time point), the data latched by the D-flip-flop (DFF1) 511 corresponds to an exclusive logical sum (Exclusive-OR) among the preceding content of the D-flip-flop (DFF3) 515, the input signal and the preceding content of the D-flip-flop (DFF0) 507, the data latched by the D-flip-flop (DFF2) 513 corresponds to the preceding content of the D-flip-flop (DFF1) 511, and the data latched by the D-flip-flop (DFF3) 515 corresponds to the preceding content of the D-flip-flop (DFF2) 513, as can be seen from Fig. 16.

Accordingly, at the time point n = 1, the content of the D-flip-flop (DFF0) is represented by $x_3 + D_0$, the content of the D-flip-flop (DFF1) is represented by $x_3 + x_0 + D_0$, the content of the D-flip-flop (DFF2) is represented by $x_1$, and the content of the D-flip-flop (DFF3) is represented by $x_2$. Further, at the time point n = 2, the content of the D-flip-flop (DFF0) is represented by $x_2 + D_1$, the content of the D-flip-flop (DFF1) is represented by $x_3 + D_0 + x_2 + D_1$, the content of the D-flip-flop (DFF2) is represented by $x_0 + x_3 + D_0$ and the content of the D-flip-flop (DFF3) is represented by $x_1$. In this way, at the time point n = 4, the content of the D-flip-flop (DFF0) is represented by $x_0 + x_3 + D_0 + D_3$, the content of the D-flip-flop (DFF1) is represented by $x_0 + x_1 + x_3 + D_0 + D_2 + D_3$, the content of the D-flip-flop (DFF2) is represented by $x_1 + x_2 + D_1 + D_2$ and the content of the D-flip-flop (DFF3) is represented by $x_2 + x_3 + D_0 + D_1$.

The synthesizing circuit 105 synthesizes on the basis of the input data D(4n), D(4n + 1), D(4n + 2) and D(4n + 3) and $x_0(n)$, $x_1(n)$, $x_2(n)$ and $x_3(n)$ the data at the time point n = 4, as shown in Fig. 3, whereon these data are outputted to the D-flip-flops 110, 111, 112 and 113, respectively. The D-flip-flops 110, 111, 112 and 113 hold the respective data and output them at a time point (n + 1) in response to the clock signal. The outputs $x_0(n + 1)$, $x_1(n + 1)$, $x_2(n + 1)$ and $x_3(n + 1)$ of the D-flip-flops 110, 111, 112 and 113, respectively, can generally be represented by the following expressions (2) to (5).

$$x_0(n + 1) = x_0(n) + x_3(n) + D(4n) + D(4n + 3) \tag{2}$$

$$x_1(n + 1) = x_0(n) + x_1(n) + x_3(n)$$
$$+ D(4n) + D(4n + 2) + D(4n + 3) \tag{3}$$

$$x_2(n + 1) = x_1(n) + x_2(n) + D(4n + 1)$$
$$+ D(4n + 2) \tag{4}$$

$$x_3(n + 1) = x_2(n) + x_3(n) + D(4n) + D(4n + 1) \tag{5}$$

By performing the synthesization in accordance with the above expressions (2) to (5) in the synthesizing circuit 105, there can be realized a parallel-input/parallel-output error-correcting code generating circuit corresponding to the shift register shown in Fig. 16. For practical application, the synthesizing circuit 105 may be constituted by using eight adder circuits, as shown in Fig. 4.

Because the error-correcting code generating circuit mentioned above is so designed as to perform the four-bit parallel processing, the number of times each of the D-flip-flops 110 to 113 is activated for the arithmetic operation can be decreased by a factor of one forth when compared with the number of times the D-flip-flop (DFF0) to D-flip-flop (DFF3) shown in Fig. 16 and designed for serial processing. By way of example, when arithmetic operation for four bits is executed, four operations at each of the D-flip-flop (DFF0) to D-flip-flop (DFF3) are required for the serial processing are operated. By contrast, with the parallel processing, a single arithmetic operation is sufficient.

Figure 5 is a table chart for illustrating comparatively the serial processing performed by the conventional shift register and the parallel processing performed by the error-correcting code generating circuit according to the instant embodiment of the invention in terms of operation overhead per f/4 (sec). With regard to the number of operations performed by the gate (such as adder circuit or the like) for the four-bit processing, the synthesizing circuit 105 comprised of the eight adder circuits is comparable to the shift register shown in Fig. 16.

The number of times the D-flip-flop is operated for the parallel processing can be significantly reduced when compared with the serial processing. The ratio of the reduction can further be increased by increasing the number of bits which undergo the parallel processing. In that case, the upper limit of the bit number is determined by the generating polynomial.

Additionally, it is noted that all the arithmetic operations have to be completed within 1/f (sec) in the case of the serial processing. By contrast, in the parallel processing, it is sufficient to complete all the operations within 4/f (sec), which in turn means that a lower-speed process can be adopted. By virtue of this feature, power consumption involved in the execution of the process itself can be reduced.

Embodiment 2

A second embodiment of the present invention is directed to a modulator apparatus which is implemented by combining an error-correcting code generating circuit and a modulator apparatus.

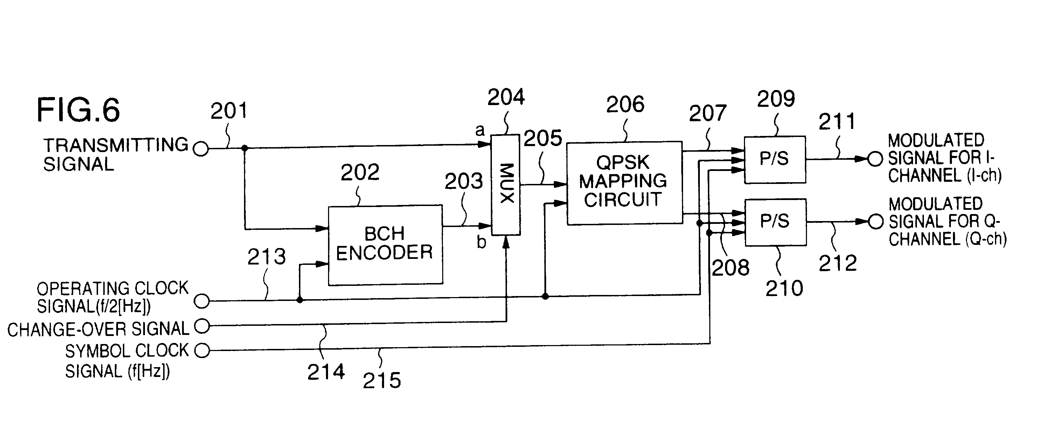

Referring to Fig. 6, the modulator apparatus now under consideration is comprised of a BCH (Bose-Chaudhuri-Hocquenghem) encoder 202 serving as the error-correcting code generating circuit described in conjunction with the first embodiment, a multiplexer (MUX) 204 for selecting a signal input (a) before inputting operation of a transmitting signal 201 to be transmitted has been completed and changing over the input (a) to an input (b) for the BCH encoder 202 upon completion of the transmitting signal input operation, to thereby output a check bit signal generated by the BCH encoder 202, a QPSK (quadrature phase-shift keying) mapping circuit 206 for converting signal bits into signal modulating point symbols, and parallel-to-serial (P/S) converters 209 and 210 for converting the parallel output of the QPSK mapping circuit 206 into serial signals to be outputted on a symbol-by-symbol basis.

Each of the parallel-to-serial converters 209 and 210 is supplied with a symbol clock signal having a frequency f (Hz), while an operation clock signal 213 of a frequency f/2 (Hz) (i.e., frequency equal to a half of the symbol clock signal) is inputted to the BCH encoder 202, the QPSK mapping circuit 206 and the parallel-to-serial converters 209 and 210, whereas a change-over signal 214 indicating the selection or change-over timing is inputted to the multiplexer (MUX) 204.

At this juncture, it is assumed that the transmitting signal 201 inputted to the modulator apparatus now under consideration is a signal of 40 bits inputted four by four bits (i.e., on a four-bit basis).

The transmitting signal 201 is inputted to the BCH encoder 202 and the multiplexer 204. The BCH encoder 202 continues to output the check bits by performing the four-bit-parallel-input and four-bit-parallel output operation described previously in conjunction with the first embodiment of the invention.

The multiplexer 204 selects the signal input (a) until the input operation of the transmitting signal 201 has been completed, to thereby send out the transmitting signal 201 on a four-bit-parallel basis. Upon completion of the inputting of the transmitting signal 201, the change-over signal 214 is inputted to the multiplexer 204, which then responds thereto by changing over input $\underline{a}$ to input $\underline{b}$ for outputting on a four-bit-parallel basis the check bits inputted from the BCH encoder 202.

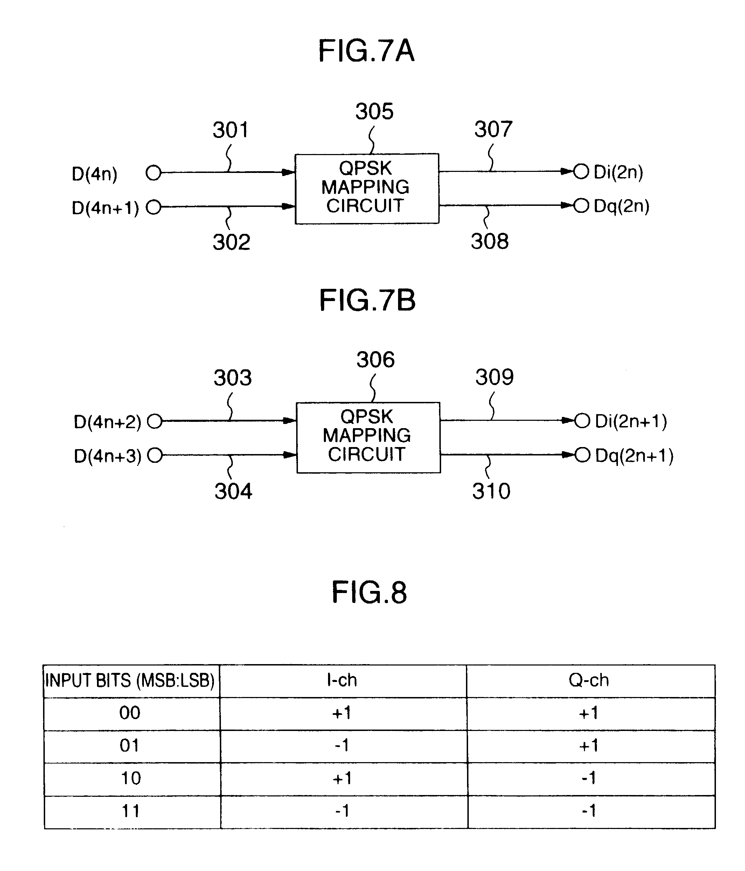

The QPSK mapping circuit 206 includes a pair of QPSK mapping circuitries 305 and 306 connected in parallel to each other, as can be seen in Fig. 7. Of the parallel signals outputted from the multiplexer 204, the signals D(4n) and D(4n + 1) are inputted to the QPSK mapping circuitry 305, while the signals D(4n + 2) and D(4n + 3) are inputted to the QPSK mapping circuitry 306. The QPSK mapping circuitry 305 outputs the values for the I-channel and Q-channel determined by bit combinations of D(4n) and D(4n + 1) as Di(2n) and Dq(2n), respectively, while the QPSK mapping circuitry 306 outputs the values for the I-channel and Q-channel determined by bit combinations of D(4n + 2) and D (4n + 3) as Di(2n + 1) and Dq(2n + 1), respectively. In this conjunction, relations between the input bit combinations and the output values for the I-channel and Q-channel values are illustrated in Fig. 8.

The signal Di(2n) outputted from the QPSK mapping circuitry 305 and the signal Di(2n + 1) outputted from the QPSK mapping circuitry 306 are inputted to the parallel-to-serial converter 209 while the signal Dq(2n) outputted from the QPSK mapping circuitry 305 and the signal Dq(2n + 1) outputted from the QPSK mapping circuitry 306 are inputted to the parallel-to-serial converter 210.

Each of the parallel-to-serial converters 209 and 210 converts the inputted parallel signal into a serial signal at a timing given by a symbol clock signal 215 to output the serial signal on a symbol-by-symbol basis. As a result of this, a modulated signal for the I-channel is outputted from the parallel-to-serial converter 209, while the parallel-to-serial converter 210 outputs a modulated signal for the Q-channel.

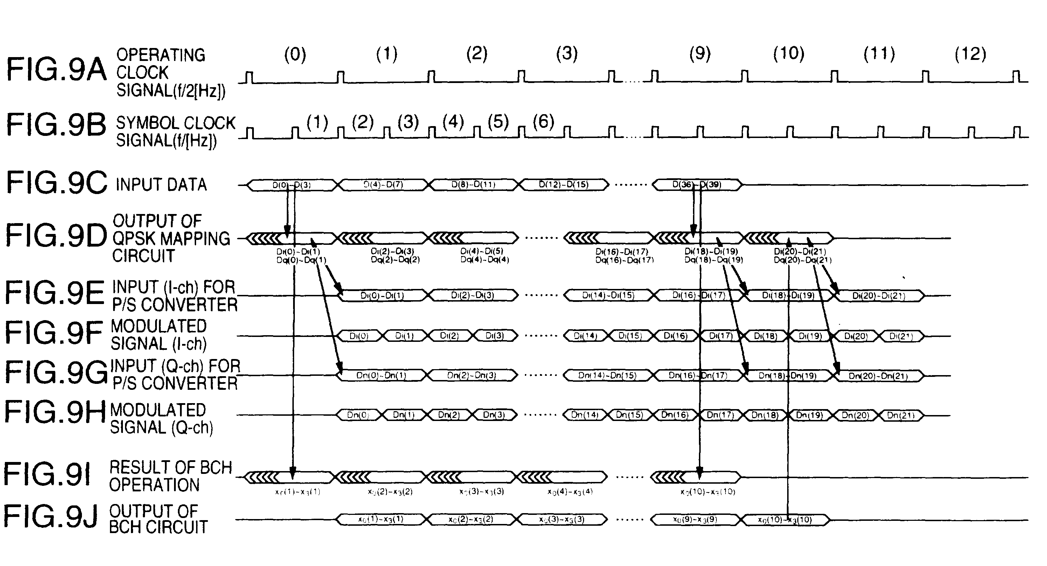

Figures 9A to 9J are timing charts for illustrating operations of the modulator apparatus now under consideration.

Referring to the figure, when the signals D(0) to D(3) are inputted in response to the zero-th operating clock, mapping to a QPSK modulation signal is performed by the QPSK mapping circuit 206. The output of the QPSK mapping circuit 206 is inputted to the parallel-to-serial converters 209 and 210 in response to the first operating clock. Subsequently, in response to the second symbol clock, data Di(0) and Dq(0) are outputted with data Di(1) and Dq(1) being outputted in response to the third symbol clock.

At the same time, the data signals D(0) to D(3) are inputted to the BCH error correcting encoder 202 in response to the zero-th operating clock, whereupon error correcting code generating operation is performed, the result of which is stored in the D-flip-flop incorporated in the encoder 202 in response to the first operating clock.

These processings are executed successively up to the ninth clock at which the final signal train is inputted.

At the tenth clock, the multiplexer 204 selects the error correcting encoder 202. Thus, the output of the error correcting encoder 202 is supplied to the QPSK mapping circuit 206, where the output of the encoder 202 undergoes the QPSK modulation.

In general, when the input to the error-correcting code generating circuit is M bits in parallel and a $2^N$ (bit/symbol) modulation technique is adopted, the operation clock signal 213 has a frequency given by $f/(M/2^N)$(Hz), where M is so selected in conformance with N that $(M/2^N)$ is an integer. In the case of the modulator apparatus according to the instant embodiment of the invention, four bits are inputted in parallel to the error-correcting code generating circuit as the data signal, and the 2 (bit/symbol) QPSK modulation technique is adopted. Consequently, the operating clock frequency is $f/2$ (Hz).

As will now be appreciated from the above description, with the modulator apparatus according to the instant embodiment of the invention, a plurality of bits can be mapped to the modulation signal points (i.e., signal points for modulation) with a single-shot of clock by virtue of the parallel processing executed by the QPSK mapping circuit 206. Owing to this feature, the operation speed can be reduced when compared with the serial processing. Further, it should be added that the QPSK mapping circuit 206 can ensure interfacing compatibility with the error-correcting code generating circuit which is equally designed to perform the parallel processing.

In the foregoing description, it has been assumed that the QPSK modulation is adopted as the modulation technique. It goes however without saying that the present invention is never restricted to any particular modulation technique but other appropriate modulation methods can equally be made use of. Among others, there may be mentioned, by way of example, DQPSK and OQPSK modulation techniques as well as BPSK, 8PSK, 16PSK, 16QAM (quadrature amplitude modulation), 16APSK, 32QAM, 64QAM, 256QAM and the like modulation technique.

Embodiment 3

A third embodiment of the present invention is directed to a modulator apparatus which includes a scrambler circuit for making random the transmitting signal trains.

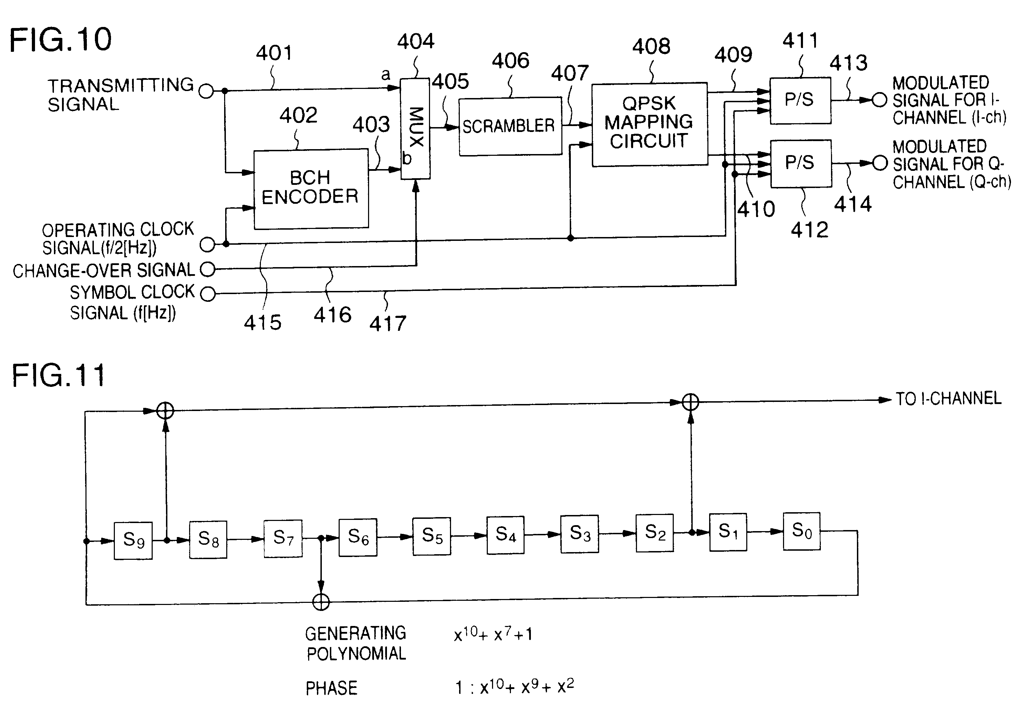

Figure 10 is a circuit diagram showing the modulator apparatus according to the third embodiment of the invention. As can be seen in the figure, a scrambler 406 is provided at the output side of the multiplexer (MUX) 404 for scrambling the output of the multiplexer 404 through parallel processing. Except for this feature, the structure of the modulator apparatus according to the instant embodiment of the invention is essentially same as that of the second embodiment (see Fig. 6).

The conventional scrambler known heretofore is ordinarily constituted by a linear feedback type shift register, as shown in Fig. 11. More specifically, Fig. 11 shows a scrambler circuit which incarnates the generating polynomial expressed as follows:

$$G(x) = x^{10} + x^7 + 1 \qquad (6)$$

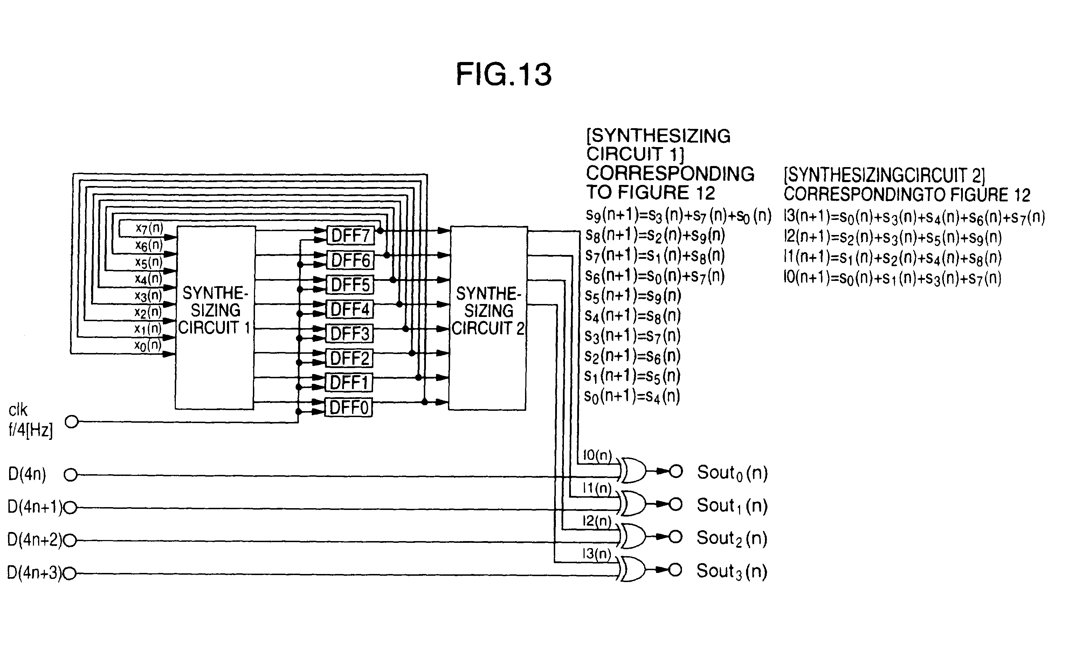

On the other hand, in the modulator apparatus now under consideration, the scrambler circuit is implemented in the form of a four-bit parallel input/ four-bit parallel output scrambler by combining the synthesizing circuits and D-flip-flops in such an arrangement as illustrated in Fig. 13. The synthesizing circuits are so arranged as to synthesize the signals stored in the individual D-flip-flops with the scrambled four-bit output signals by using the input signals D(4n) to D(4n + 3) and the signal $s_0(n)$ to $s_9(n)$ fed back from the individual D-flip-flops.

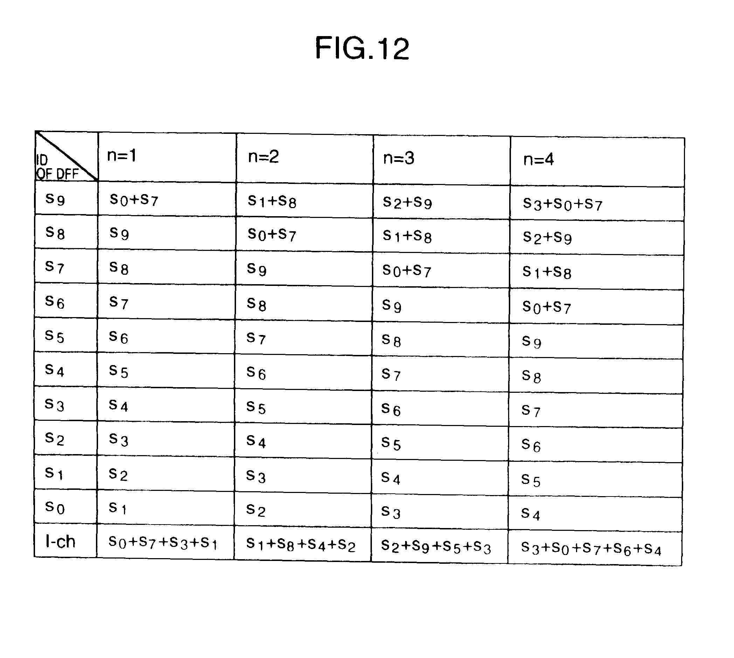

Figure 12 shows a table containing the data latched by ten D-flip-flops of the conventional scrambler (Fig. 11). In the figure, the leftmost column contains identifiers $s_0$ to $s_9$ of the D-flip-flops, respectively, together with an identifier I-ch for the output circuit or channel. Further, in the columns labeled "n = 1", "n = 2", "n = 3" and "n = 4", there are indicated data contents latched by the D-flip-flops, respectively, at time points n = 1, n = 2, n = 3 and n = 4 in this sequence together with the data content outputted to the channel I-ch. In this conjunction, it should be appreciated that the identifiers $s_0$ to $s_9$ are represented by the data stored initially in the associated D-flip-flops, respectively.

The successive four-bit outputs of this scrambler circuit are expressed as follows:

$$Sout_0(n) = s_0(n) + s_1(n) + s_3(n) + s_7(n) \qquad (7)$$

$$Sout_1(n) = s_1(n) + s_2(n) + s_4(n) + s_8(n) \qquad (8)$$

$$Sout_2(n) = s_2(n) + s_3(n) + s_5(n) + s_9(n) \qquad (9)$$

$$Sout_3(n) = s_0(n) + s_3(n) + s_4(n) + s_6(n) + s_7(n) \qquad (10)$$

In the scrambler 406 according to the instant embodiment of the invention, the synthesizing circuits synthesizes the exclusive logical sums (Exclusive-OR) of the pairs $Sout_0(n)$ and $D(4n)$, $Sout_1(n)$ and $D(4n + 1)$, $Sout_2(n)$ and $D(4n + 2)$, and $Sout_3(n)$ and $D(4n + 3)$ by using the data $D(4n)$ to $D(4n + 3)$ and $s_0(n)$ to $s_9(n)$.

On the other hand, in the scrambler circuit shown in Fig. 11, contents of the data latched by the individual D-flip-flops at the time point 4n are expressed as follows:

$$s_9(n + 1) = s_3(n) + s_0(n) + s_7(n) \qquad (11)$$

$$s_8(n + 1) = s_2(n) + s_9(n) \qquad (12)$$

$$s_7(n + 1) = s_1(n) + s_8(n) \qquad (13)$$

$$s_6(n + 1) = s_0(n) + s_7(n) \qquad (14)$$

$$s_5(n + 1) = s_9(n) \qquad (15)$$

$$s_4(n + 1) = s_8(n) \qquad (16)$$

$$s_3(n + 1) = s_7(n) \qquad (17)$$

$$s_2(n + 1) = s_6(n) \qquad (18)$$

$$s_1(n + 1) = s_5(n) \qquad (19)$$

$$s_0(n + 1) = s_4(n) \qquad (20)$$

In the scrambler 406 according to the instant embodiment of the invention, the data $s_0(n + 1)$ to $s_9(n + 1)$ latched in succession by the individual D-flip-flops are synthesized by the synthesizing circuits in accordance with the expressions (11) to (20) by using the data $s_0(n)$ to $s_9(n)$, respectively. In this manner, the scrambler 406 executes the parallel processing for the four-bit data.

With the modulator apparatus according to the third embodiment of the invention, the scramble processing is executed in parallel. Thus, the arithmetic operations can be performed at a low speed or rate.

In this conjunction, it is noted that in the case of the serial processing, all the arithmetic operations have to be completed within 1/f (sec). By contrast, in the parallel processing, it is sufficient to complete all the operations within 4/f (sec), which in turn means that a lower speed process can be adopted. By virtue of this feature, power consumption involved in the execution of the process itself can be reduced. To say in another way, for a same process as that of the serial processing, the operation can be achieved at a speed four times as high as the speed in the serial processing.

Embodiment 4

A fourth embodiment of the invention is directed to a modulator apparatus in which the error-correcting code generating circuits are provided for I-channel and Q-channel, respectively.

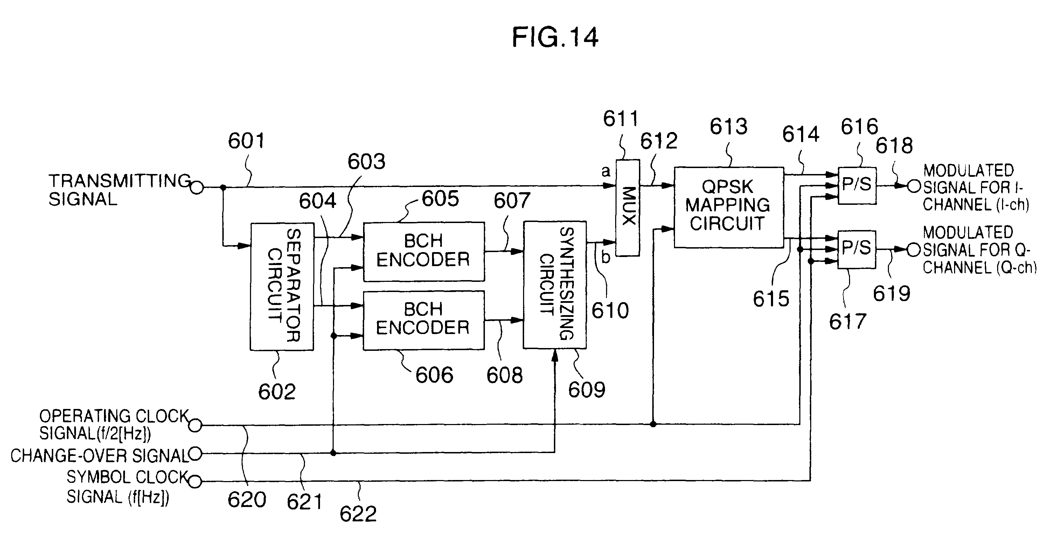

Figure 14 is a circuit diagram showing a circuit configuration of the modulator apparatus according to the fourth embodiment of the invention. As can be seen in the figure, the modulator apparatus now under consideration is comprised of a separator circuit 602 for separating a four-bit-parallel transmitting signal 601 into a signal I-ch for the I-channel and a signal Q-ch for the Q-channel, error-correcting code generating circuits 605 and 606 for generating check bits for the separated signals I-ch and Q-ch, respectively, and a synthesizing circuit 609 for synthesizing the outputs of the error-correcting code generating circuits 605 and 606 into a four-bit-parallel signal. Except for the circuit arrangement mentioned above, the structure of the modulator apparatus according to the instant embodiment is essentially same as that of the modulator apparatus according to the second embodiment (see Fig. 6).

In the case of the modulation technique based on two or more bits per symbol such as the QPSK modulation technique and others, error is detected for each of the signals I-ch and Q-ch on a signal plane, whereby error correction is performed for each of the signals I-ch and Q-ch. The instant embodiment of the invention is directed to the modulator apparatus capable of performing the operation mentioned above.

A four-bit-parallel transmitting signal 601 is inputted not only to a multiplexer (MUX) 611 but also to the separator circuit 602. The separator circuit 602 is designed to separate the four-bit input signal such that odd-numbered bits of the four bits are outputted as the signal I-ch with even-numbered bits being outputted as the signal Q-ch separately.

The structure and operation of the error-correcting code generating circuit 605, 606 are essentially identical with those described hereinbefore in conjunction with the first embodiment of the invention. Namely, the error-correcting code generating circuits 605 and 606 are so designed as to generate two-bit check bits corresponding to the two-bit parallel input signals, respectively.

On the other hand, the synthesizing circuit 609 operates to synthesize the outputs of the error-correcting code generating circuits 605 and 606 to thereby restore the original bit positions of the signals I-ch and Q-ch separated by the separator circuit 602.

In other respects, operation of the modulator apparatus according to the instant embodiment of the invention is essentially same as that of the modulator apparatus described hereinbefore in connection with the second embodiment of the invention.

With the structure of the modulator apparatus according to the fourth embodiment of the invention, the number of bits of the signals inputted to and outputted from each of the error-correcting code generating circuits 605 and 606 is decreased to a half of the input/output bit number of the QPSK mapping circuit 613 because of the bit separation effectuated by the separator circuit 602.

In the modulator apparatus according to the instant embodiment of the invention, the error correcting code can be added to the data for the channels I-ch and Q-ch, respectively, by employing two error-correcting code generating circuits for the parallel processing, the separating circuit and the synthesizing circuit.

Embodiment 5

A fifth embodiment of the present invention is directed to a modulator apparatus designed for effecting encoding operation and the scramble processing for the signals for the I-channel and the Q-channel, respectively.

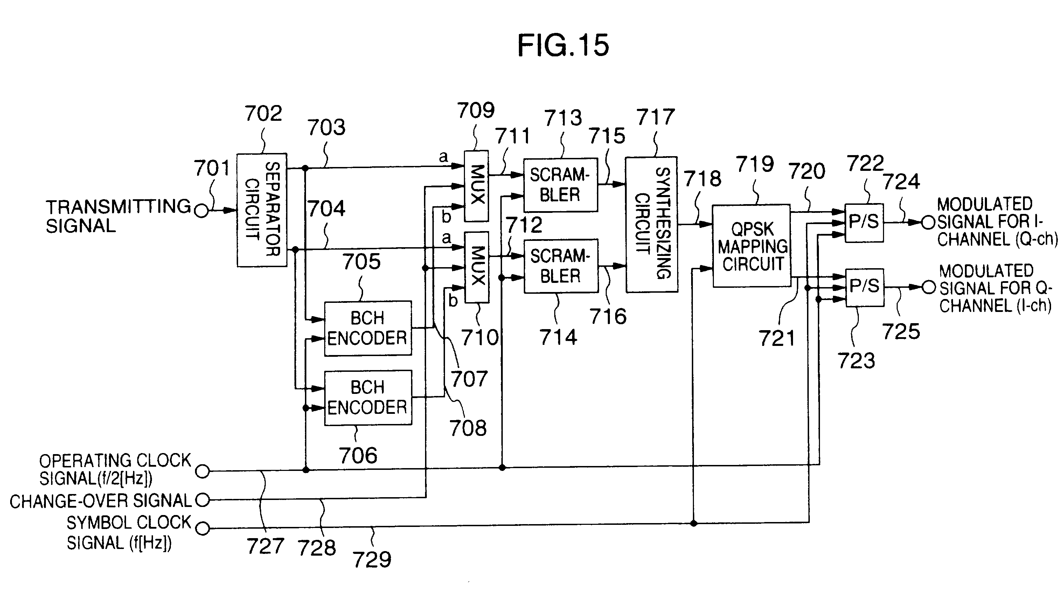

Figure 15 is a circuit diagram showing a circuit configuration of the modulator apparatus according to the fifth embodiment of the invention. As can be seen in the figure, the modulator apparatus under consideration is comprised of a separator circuit 702 for separating a transmitting signal 701 into bit signals for the channels I-ch and Q-ch, respectively, error-correcting code generating circuits (BCH encoders) 705 and 706 for generating check bits for the bits of the channel signals, respectively, multiplexers (MUX) 709 and 710 for selecting the channels for the output signal, scramblers 713 and 714 for executing scramble processings separately for the signals I-ch and Q-ch, respectively, the scrambler 713 for restoring the bit positions of signals I-ch and Q-ch outputted from the separator 702, a QPSK mapping circuit 719 for mapping a plurality of bits to the modulation signal points (i.e., signal points for modulation), and parallel-to-serial (P/S) converters 722 and 723 for converting the parallel input signals into serial output signals, respectively.

In the case of the modulation technique based on two or more bits per symbol such as the QPSK modulation and others, error correction is performed for each of the signals for the channels I-ch and Q-ch on a signal plane, whereby error correction is performed for each of the signals I-ch and Q-ch. The instant embodiment of the invention is directed to the modulator apparatus capable of performing the operation mentioned above.

The separator circuit 702 is designed to separate the four-bit input signal such that odd-numbered bits of the four bits are outputted as the signal I-ch (i.e., data signal for the channel I) with even-numbered bits being outputted as the signal Q-ch (i.e., signal for the channel Q) separately from the signal I-ch. The signals as separated are inputted to the multiplexers 709 and 710 and the error-correcting code generating circuits 705 and 706, respectively. Each of the error-correcting code generating circuits 705 and 706 is designed to generate the check bit for the signals of the channel I-ch and Q-ch, respectively, as elucidated hereinbefore in conjunction with the fourth embodiment of the invention.

So long as the transmitting signal 701 is inputted, the multiplexers 709 and 710 send out the signal bits for the respective channels sent from the separator circuit 702. Upon completion of the inputting of the transmitting signal 701, the check bits are outputted from the error-correcting code generating circuits (BCH encoders) 705 and 706, respectively.

Each of the scramblers 713 and 714 is implemented essentially in a same structure as that of the modulator apparatus described hereinbefore in conjunction with the third embodiment so as to scramble the signals for the channels I-ch and Q-ch separately from each other.

The outputs of the scramblers 713 and 714 are synthesized by a synthesizing circuit 717 into a signal having the bits disposed before the separation into the signals I-ch and Q-ch by the separator circuit 702, wherein the output of the synthesizing circuit 717 is inputted to the QPSK mapping circuit 719. Operation of the QPSK mapping circuit 719 and the parallel-to-serial converters 722 and 723 are essentially same as those of the modulator apparatus described hereinbefore in conjunction with the second embodiment of the invention.

As is apparent from the above description, in the case of the modulator apparatus according to the fifth embodiment of the invention, the bits are separated into halves by the separator circuit 702 such that the number of bits inputted to and outputted from the error-correcting code generating circuit 705, 706 and the scrambler 713, 714, respectively, is equal to a half of the number of bits inputted to and outputted from the QPSK mapping circuit 719.

With the modulator apparatus including the two error-correcting code generating circuits each designed for parallel processing, the two scramblers, the separator circuit and the synthesizing circuit, the error correcting code generation processing and the scramble processing can be performed separately for the data for the channels I-ch and Q-ch, respectively.

As will be understood from the foregoing description, because the error-correcting code generating circuit according to the invention is capable of performing the parallel processing, a low-speed process can be used with the power consumption of the process itself being reduced. On the other hand, when a process same as the serial processing is employed, high-speed operation can be achieved.

Furthermore, because there is employed not only the modulator apparatus but also the modulating circuit and the scrambler circuit in the error-correcting code generating circuit according to the invention, operation speed can be lowered with the power consumption being reduced. On the other hand, when the power consumption comparable to that demanded for execution of the serial processing is tolerable, high-speed operation can be achieved.

Many modifications and variations of the present invention are possible in the light of the above techniques. It is therefore to be understood that within the scope of the appended claims, the invention may be practiced otherwise than as specifically described.

## Claims

1. An error-correcting code generating circuit, comprising:

   a shift register (110, 111, 112, 113) incarnating a generating polynomial;
   exclusive logical sum means (503); and
   logical circuit means (105) for performing arithmetic operations on N bits (114, 115, 116, 117) (where N represents an integer not smaller than two) held by said shift register at one time with a clock (118) having a frequency corresponding to 1/N on the basis of N bits (101, 102, 103, 104)(where N represents an integer not smaller than two) inputted in parallel, to thereby generate an error-correcting code of N bits with a single-shot of clock.

2. A modulator apparatus, comprising:

   parallel-input/parallel-output error-correcting code generating circuit means (Fig. 1) for arithmetically generating an error-correcting code of plural bits with a single-shot of clock; and
   parallel-input/parallel-output modulator means (209) for performing mapping of the plural bits to modulation signal points with a single-shot of clock.

3. A modulator apparatus according to claim 2, wherein said parallel-input/parallel-output error-correcting code generating circuit means (202) includes error-correcting code generating circuits (605, 606) for two channels (I, Q), respectively.

4. A modulator apparatus according to claim 2, further comprising parallel-input/parallel-output scrambler circuit means (406) for scrambling a signal inputted to said parallel-input/parallel-output modulator means through parallel processing.

5. A modulator apparatus according to claim 3, further comprising parallel-input/parallel-output scrambler circuit means (405) for scrambling a signal inputted to said parallel-input/parallel-output modulator means through parallel processing.

6. A modulator apparatus according to claim 4, wherein said parallel-input/parallel-output scrambler circuit means includes scrambler circuits (713, 714) for two channels, respectively.

## FIG.1

## FIG.2

| D(3) | D(2) | D(1) | D(0) |
|------|------|------|------|
| D(7) | D(6) | D(5) | D(4) |
| D(11) | D(10) | D(9) | D(8) |
| D(14) | D(13) | D(12) | D(12) |
| D(19) | D(18) | D(17) | D(16) |
| D(23) | D(22) | D(21) | D(20) |
| D(27) | D(26) | D(25) | D(24) |
| D(31) | D(30) | D(29) | D(28) |
| D(35) | D(34) | D(33) | D(32) |
| D(39) | D(38) | D(37) | D(36) |

# FIG.3

| IDENTIFIER OF D-ELIP ELOP | TIME POINTS | | | | |
|---|---|---|---|---|---|
| | n=0 | n=1 | n=2 | n=3 | n=4 |
| DFF0 | $x_0$ | $x_3+D_0$ | $x_2+D_1$ | $x_1+D_2$ | $x_0+x_3+D_0+D_3$ |
| DFF1 | $x_1$ | $x_0+x_3+D_0$ | $x_2+x_3+D_0+D_1$ | $x_1+x_2+D_1+D_2$ | $x_0+x_1+x_2+D_0+D_1+D_2$ |
| DFF2 | $x_2$ | $x_1$ | $x_0+x_3+D_0$ | $x_2+x_3+D_0+D_1$ | $x_1+x_2+D_1+D_2$ |
| DFF3 | $x_3$ | $x_2$ | $x_1$ | $x_0+x_3+D_0$ | $x_2+x_3+D_0+D_1$ |

# FIG.4

$x_0(n)$
$D_3=D(4n+3)$ → $x_0(n+1)$

$x_3(n)$
$D_0=D(4n+0)$ → $x_1(n+1)$

$x_2(n)$
$D_1=D(4n+1)$ → $x_2(n+1)$

$x_1(n)$
$D_2=D(4n+2)$ → $x_3(n+1)$

# FIG.5

| ITEM | SERIAL PROCESSING | PARALLEL PROCESSING |
|---|---|---|
| NUMBER OF OPERATIONS PERFORMED BY DFF PER f/4(sec) | 16(4 BITS × 4 TIMES) | 4 |
| NUMBER OF ARITHMETIC OPERATION PERFORMED BY GATE PER f/4(sec) | 8(2 BITS × 4 TIMES) | 8 |
| REMARKS | ALL OPERATIONS HAS TO BE COMPLETED WITHIN 1/f(sec) | ALL OPERATIONS CAN BE COMPLETED WITHIN 4/f(sec) |

FIG.6

EP 0 821 492 A2

## FIG.7A

## FIG.7B

## FIG.8

| INPUT BITS (MSB:LSB) | I-ch | Q-ch |
|---|---|---|
| 00 | +1 | +1 |
| 01 | -1 | +1 |
| 10 | +1 | -1 |
| 11 | -1 | -1 |

FIG.9A OPERATING CLOCK SIGNAL(f/2[Hz])

FIG.9B SYMBOL CLOCK SIGNAL(f/[Hz])

FIG.9C INPUT DATA

FIG.9D OUTPUT OF QPSK MAPPING CIRCUIT

FIG.9E INPUT (I-ch) FOR P/S CONVERTER

FIG.9F MODULATED SIGNAL (I-ch)

FIG.9G INPUT (Q-ch) FOR P/S CONVERTER

FIG.9H MODULATED SIGNAL (Q-ch)

FIG.9I RESULT OF BCH OPERATION

FIG.9J OUTPUT OF BCH CIRCUIT

EP 0 821 492 A2

## FIG.10

TRANSMITTING SIGNAL ○ — 401 — a

402 — 403

MUX 404 — 405

SCRAMBLER 406 — 407

QPSK MAPPING CIRCUIT 408 — 409 — P/S 411 — 413 → MODULATED SIGNAL FOR I-CHANNEL (I-ch)

BCH ENCODER

P/S 412 — 414 → MODULATED SIGNAL FOR Q-CHANNEL (Q-ch)

410

OPERATING CLOCK SIGNAL (f/2[Hz]) ○

CHANGE-OVER SIGNAL ○

SYMBOL CLOCK SIGNAL (f[Hz]) ○

415    416    417

## FIG.11

→ TO I-CHANNEL

$S_9$ → $S_8$ → $S_7$ → $S_6$ → $S_5$ → $S_4$ → $S_3$ → $S_2$ → $S_1$ → $S_0$

GENERATING POLYNOMIAL          $x^{10} + x^7 + 1$

PHASE          $1 : x^{10} + x^9 + x^2$

EP 0 821 492 A2

# FIG.12

| ID OF DFF | n=1 | n=2 | n=3 | n=4 |
|---|---|---|---|---|
| $s_9$ | $s_0+s_7$ | $s_1+s_8$ | $s_2+s_9$ | $s_3+s_0+s_7$ |
| $s_8$ | $s_9$ | $s_0+s_7$ | $s_1+s_8$ | $s_2+s_9$ |
| $s_7$ | $s_8$ | $s_9$ | $s_0+s_7$ | $s_1+s_8$ |
| $s_6$ | $s_7$ | $s_8$ | $s_9$ | $s_0+s_7$ |
| $s_5$ | $s_6$ | $s_7$ | $s_8$ | $s_9$ |
| $s_4$ | $s_5$ | $s_6$ | $s_7$ | $s_8$ |
| $s_3$ | $s_4$ | $s_5$ | $s_6$ | $s_7$ |
| $s_2$ | $s_3$ | $s_4$ | $s_5$ | $s_6$ |
| $s_1$ | $s_2$ | $s_3$ | $s_4$ | $s_5$ |
| $s_0$ | $s_1$ | $s_2$ | $s_3$ | $s_4$ |
| I-ch | $s_0+s_7+s_3+s_1$ | $s_1+s_8+s_4+s_2$ | $s_2+s_9+s_5+s_3$ | $s_3+s_0+s_7+s_6+s_4$ |

# FIG.13

[SYNTHESIZING CIRCUIT 1] CORRESPONDING TO FIGURE 12

$s_9(n+1)=s_3(n)+s_7(n)+s_0(n)$
$s_8(n+1)=s_2(n)+s_9(n)$
$s_7(n+1)=s_1(n)+s_8(n)$
$s_6(n+1)=s_0(n)+s_7(n)$
$s_5(n+1)=s_9(n)$
$s_4(n+1)=s_8(n)$
$s_3(n+1)=s_7(n)$
$s_2(n+1)=s_6(n)$
$s_1(n+1)=s_5(n)$
$s_0(n+1)=s_4(n)$

[SYNTHESIZINGCIRCUIT 2] CORRESPONDINGTO FIGURE 12

$I3(n+1)=s_0(n)+s_3(n)+s_4(n)+s_6(n)+s_7(n)$
$I2(n+1)=s_2(n)+s_3(n)+s_5(n)+s_9(n)$
$I1(n+1)=s_1(n)+s_2(n)+s_4(n)+s_8(n)$
$I0(n+1)=s_0(n)+s_1(n)+s_3(n)+s_7(n)$

$x_7(n)$
$x_6(n)$
$x_5(n)$
$x_4(n)$
$x_3(n)$
$x_2(n)$
$x_1(n)$
$x_0(n)$

SYNTHE-SIZING CIRCUIT 1

DFF7
DFF6
DFF5
DFF4
DFF3
DFF2
DFF1
DFF0

SYNTHE-SIZING CIRCUIT 2

clk
f/4[Hz]

$D(4n)$

$D(4n+1)$

$D(4n+2)$

$D(4n+3)$

$I0(n)$ — $Sout_0(n)$

$I1(n)$ — $Sout_1(n)$

$I2(n)$ — $Sout_2(n)$

$I3(n)$ — $Sout_3(n)$

# FIG.14

# FIG.15

EP 0 821 492 A2

# FIG.16
# PRIOR ART